# EUROPÄISCHE PATENTSCHRIFT

(11) **EP 2 112 553 B1**
(45) Veröffentlichungstag und Bekanntmachung des Hinweises auf die Patenterteilung: **08.02.2012**
(21) Anmeldenummer: 08007753.0
(22) Anmeldetag: 22.04.2008
(51) Int. Cl.: G03F 3/10, H04N 1/60

(54) **Herstellung von Testdrucken**
Manufacture of colour proofs
Fabrication d'épreuves en couleur

(43) Veröffentlichungstag der Anmeldung: 28.10.2009
(73) Patentinhaber: GMG GmbH & Co. KG, 72072 Tübingen (DE)
(72) Erfinder: Radtke, David, 72070 Tübingen (DE); Wurster, Jürgen, 72135 Dettenhausen (DE)
(74) Vertreter: Stenger, Watzke & Ring

(56) Entgegenhaltungen:
- EP-A- 1 231 774
- EP-A- 1 648 157
- WO-A-02/30103
- WO-A-2007/093411
- US-A- 5 270 734
- US-A1- 2004 201 696
- US-A1- 2006 251 296

## Beschreibung

Die vorliegende Erfindung betrifft ein Verfahren zur Herstellung von Testdrucken, sogenannten Proofs.

Industrielle Druckmaschinen können üblicherweise unter Verwendung standardisierter Papiere und Druckfarben ein gewisses Spektrum von Farben und Schwarz drucken. Dieser üblicherweise darstellbare Druckbereich wird als sogenannter Farbraum bezeichnet. Jegliche Kombination der vorgegebenen Druckfarben, jeweils in einem Spektrum von 0% bis 100%, einschließlich Schwarz ergibt einen druckbaren Farbpunkt.

Digitale Druckdaten definieren je nach Auflösung den jeweils zu druckenden Farbpunkt im Farbraum. Farbräume sind beispielsweise ISO-Farbräume für den Offsetdruck (z. B. ISO 39), PSR-Farbräume, die im Tiefdruckbereich verwendet werden, Webcoating-Farbräume, die beispielsweise für den Rollenoffset verwendet werden und dergleichen.

Um die Qualität eines Layouts prüfen zu können, wäre es nunmehr normalerweise erforderlich, die entsprechende Druckmaschine einzurichten und in Betrieb zu nehmen, um ein entsprechendes Bild zur Ergebnisüberprüfung auszudrucken. Um diesen überaus hohen wirtschaftlichen Aufwand zu verringern, ist es inzwischen bekannt, auf vergleichsweise kostengünstigen Digitaldruckem Testdrucke auszuführen.

Der jeweilige Digitaldrucker seinerseits kann ein anderes Farbspektrum im Vergleich zur industriellen Druckmaschine erstellen.

Auch dieser Farbraum des Digitaldruckers ergibt sich, wenn die bei diesem Digitaldrucker verfügbaren Farben sowie Schwarz in sämtlichen Kombinationen gedruckt werden. Auch dabei geht man aus von Standardfarben, die für diesen Drucker oder Druckertyp üblich sind, und Standardpapieren für Digitaldrucker.

Aus dem Vergleich der beiden Farbräume ergeben sich Konvertierungstabellen, so dass eine bestimmte Farbe im Farbraum der industriellen Druckmaschine eindeutig darstellbar ist an einem bestimmten Punkt im Farbraum des Digitaldruckers.

Derartige Verfahren sind bekannt und beispielsweise beschrieben in der WO 2007/093411, sowie in der EP-A-1231774, der EP-A-1648157 und der US-A-2004201696.

Nach der Konvertierung der Druckdaten von einem Farbraum in einen anderen könnte nun das Testbild auf dem Digitaldrucker erstellt werden.

Es gibt jedoch bekanntermaßen Parameter, die die Standardbedingungen verändern, so dass bezüglich des konkreten Digitaldruckers sogenannten Kalibrierungen erforderlich sind. Solche Veränderungen betreffen beispielsweise den Farbort, der sich verändert, beispielsweise hervorgerufen durch Produktionstoleranzen der Farben und Papier. Auch das Farbannahmeverhalten von Papieren variiert ebenso wie die Mechanik des Druckers und der Druckkopf gewissen Verschleißerscheinungen unterliegen.

Statt Konvertierungstabellen anzupassen, man spricht von sogenannten Profilen, verwendet man Kalibrierungstabellen. Diese werden auf die farbraumkonvertierten Daten angewandt, um die Daten an den konkreten Zustand des vorliegenden Digitaldruckers anzupassen.

Die Kalibrierung wird üblicherweise so durchgeführt, dass ein Testbild oder ein Teststreifen gedruckt wird, der bestimmte Farbfelder darstellt. Das konkret gedruckte Ergebnis wird mit einem druckertypischen Sollbild verglichen. Dazu erfolgt eine exakte Vermessung des gedruckten Teststreifens und die Ergebnisdaten werden mit den Solldaten verglichen. Die entsprechenden Abweichungen ergeben Kalibrierungsdaten, die dann in der jeweiligen Kalibrierungstabelle ergänzt oder überlagernd eingesetzt werden.

Es hat sich nun in der Praxis herausgestellt, dass die Anwendung der zum Stand der Technik beschriebenen Verfahren immer noch Abweichungen hervorbringen, so dass die Ergebnisse starken Variationen unterliegen. Die Ergebnisse sind nicht immer beliebig reproduzierbar und die Genauigkeit bei der Erstellung der Kalibrierungsdaten lässt zu wünschen übrig.

Ausgehend vom vorbeschriebenen Stand der Technik liegt der vorliegenden Erfindung die **Aufgabe** zugrunde, ein Verfahren zur Herstellung von Testdrucken dahingehend zu verbessern, dass dieses reproduzierbare Testdrucke in einem engen Abweichungsspektrum mit hoher Genauigkeit bei größtmöglicher Druckflexibilität hervorbringt. Gleichzeitig wird die Sicherheit bei der Benutzung der Verfahrenssoftware deutlich erhöht, indem logische Verknüpfungen in der Software Benutzerfehler abfangen.

Zur technischen **Lösung** dieser Aufgabe wird mit der Erfindung vorgeschlagen ein Verfahren mit den Merkmalen des Patentanspruches 1. Weitere Vorteile und Merkmale der Erfindung ergeben sich aus den Unteransprüchen.

Gemäß der Erfindung werden die Druckdaten, die in einem vorgegebenen Farbraum vorliegen, unter Verwendung von Konvertierungstabellen in den Farbraum des Digitaldruckers transformiert. Dabei wird von einem gegebenen Standardzustand des Digitaldruckers ausgegangen. So können beispielsweise bestimmte Papiertypen zu unterschiedlichen Grundzuständen und damit zu unterschiedlichen Farbraumtransformationstabellen bzw. Farbraumkonvertierungstabellen führen.

Die transformierten Daten werden nunmehr durch Korrekturdaten bereinigt. Die Korrekturdaten ihrerseits sind das Ergebnis einer sogenannten Kalibrierung. Dabei wird mit dem Digitaldrucker ein vorgegebenes Farbspektrum ausgedruckt, das Druckergebnis vermessen und mit einem Sollergebnis verglichen.

Für die Vermessung stehen im Stand der Technik unterschiedliche Messgeräte zur Verfügung. Es hat sich gezeigt, dass die jeweilige Wahl des Messgerätes einen Einfluss auf die Kalibrierungsergebnisse hat.

Erfindungsgemäß wird somit auch bei der Kalibrierung berücksichtigt, welches Messgerät zum Einsatz kommt, um auf diese Weise die Genauigkeit der Daten erheblich zu erhöhen. Dies erfolgt automatisiert.

Es hat sich gezeigt, dass bereits diese ergänzende Zustandsdefinition eine erhebliche Verbesserung der Ergebnisse mit sich bringt.

Dabei ist wichtig, dass die Kalibrierungen für die verschiedenen Messgeräte nun in einem Set zusammen gefasst werden und das Set mit Toleranzen versehen werden kann. Man spricht von einem "Kalibrierungs-Set".

Bei aktuellen Messgeräten ist es möglich, dass der jeweils zur Kalibrierung verwendete Computer den Messgerätetyp direkt abfragt. Dadurch wird das Verfahren in Bezug auf diesen Punkt weitgehend automatisiert.

Gemäß einem vorteilhaften Vorschlag der Erfindung berücksichtigt der jeweilige für die Kalibrierung zu druckende Farbstreifen, auch Teststreifen, Testbild oder dergleichen bezeichnet, bereits das jeweilige Messgerät. Es können auf diese Weise Teststreifen vorgegeben werden, die je nach Messgerät zu verwenden sind. Damit ist der zu druckende Testdatensatz ebenso eindeutig definiert wie der mit dem Messergebnis zu vergleichende Solldatensatz. Die Auswahl dieser Daten kann nach Abfrage des vorhandenen Messgerätes automatisch erfolgen. Dies bedeutet, dass die Sollwerte für die verschiedenen Messgeräte unterschiedlich sind, jedoch alle zum identischen Kalibrierungsergebnis führen.

Aus den Abweichungen, die sich bei der Kalibrierung ergeben, kann das System auf einfache Weise zunächst einmal die Richtigkeit der Einstellungen überprüfen.

Üblicherweise erkennt das System automatisch welches Messgerät angeschlossen ist, aber auch Drucker liefern Informationen über eingesetzte Tintensätze und dergleichen. Das System vermag beispielsweise zu erkennen, dass das falsche Papier in den Drucker eingelegt ist, oder es vermag einfach zu erkennen, dass die gedruckten Ergebnisse nach dem Soll-Ist-Vergleich in einer Weise abweichen, die eine Kalibrierung erforderlich machen. Die Kalibrierung kann entweder automatisch angestoßen oder durch eine Meldung vorbereitet werden.

In vorteilhafter Weise ermöglicht die Erfindung, in Bezug auf die Kalibrierungsdaten Gültigkeitskontrollen durchzuführen. Dies kann beispielsweise einstellbar sein, etwa im Sinne von "bei jedem Druckjob", "alle X Druckjobs", alle X Stunden, alle X Tage usw.. Dabei gibt es zwei Möglichkeiten der Gültigkeitskontrolle:
1) Man prüft mit dem gesamten Testchart, das auch für die Kalibrierung verwendet wird.
2) Man prüft mit einem Testchart welches eine geeignete Auswahl der Testchartfelder des Kalibrierungstestcharts beinhaltet. Somit kann ein "Schnelltest" durchgeführt werden.

Die Toleranzen für die Kalibrierungsergebnisse sind mit den Sollwerten verknüpft. Toleranzen und Gültigkeitskontrollen sind pro Kalibrierungs-Set definierbar. Somit können beispielsweise für ein hochwertiges Papier engere Toleranzen definiert werden als für ein Papier geringerer Qualität. Insbesondere kann auch eine Art Verfallszeitraum für das Kalibrierungsergebnis eingestellt werden, so dass beispielsweise nach einer gewissen Zeit, zum Beispiel einer Woche, die Kalibrierungsdaten automatisch ungültig werden.

Durch diese erfindungsgemäße Ergänzung wird eine sehr hohe Produktionssicherheit erreicht, da die Gültigkeitskriterien sicherstellen, dass die Kalibrierungsdaten sehr aktuell auf den Ist-Zustand zutreffen. Druckkopfverschleiß, Verschleiß in der Mechanik, der Führungen und dergleichen, aber auch Änderungen des Farbannahmeverhaltens des Papiers, die Änderungen der Farborte und dergleichen wirken sich somit kaum mehr aus. Zudem erlaubt das System nicht, dass Jobs unkalibriert ausgegeben werden wodurch die Sicherheit für den Benutzer deutlich erhöht wird.

Gemäß der Erfindung kann ein Toleranzspektrum definiert werden, in welchem sich aus dem Soll-/Ist-Vergleich ergebende Abweichungen bewegen können. So kann es dem Benutzer überlassen werden, für den jeweiligen Job auch eine größere Abweichung als akzeptabel zuzulassen, oder es kann das Spektrum von der Software automatisch überprüft werden.

In vorteilhafter Weise werden die Abweichungen zu Sollwerten auf dem Proof als Textlabel mit ausgedruckt. Der Benutzer kann somit für den jeweiligen Druck genau bestimmen, unter welcher Vorgabe der Druck erfolgt ist. Weiterhin wird das Datum der letzten Kalibrierung auf dem Proof vermerkt. Zudem wird vermerkt, welches Kalibrierungs-Set verwendet wurde, das wiederum eindeutig die Sollwerte sowie die Toleranzen und Gültigkeitsparameter definiert. Der Benutzer kann mit diesen Angaben sehr einfach erkennen, ob die technischen Parameter des Proofs inklusive Kalibrierung in Ordnung sind. Grobe Benutzerfehler oder Nachlässigkeiten (Benutzer hat Drucker lange nicht kalibriert) können mit Hilfe des Labels sofort erkannt werden.

Ein weiterer besonderer Vorteil der Erfindung ergibt sich daraus, dass ergebnisgleiche Kombinationen von Transformationstabellen und Kalibrierungsdateien einer Standardauswahl zugeordnet werden. Auf diese Weise kann, sofern mehrere unterschiedliche Drucker vorhanden sind, ein Auslastungsausgleich erfolgen.

Ausgangspunkt für die Herstellung von Testdrucken bzw. Proofs ist immer, dass der Bedienperson natürlich bekannt ist, in welchem Farbraum welchen industriellen Druckmaschinentyps endgültig ein Druck erfolgen soll. Weiterhin ist dem Nutzer bzw. dem System selbstverständlich bekannt, welche Digitaldrucker zur Verfügung stehen mit welchen Zuständen und Modi.

Weiterhin ist durch die gültigkeitsabhängige Kalibrierung dem System bekannt, welche jeweiligen Ergebnisse erzielt werden.

Auf diese Weise ist das System in der Lage, für Kombinationen von Transformationstabellen und Kalibrierungsdateien die jeweiligen Ergebnisse zu bewerten und dabei ergebnisgleiche Kombinationen herauszufinden.

So kann beispielsweise dem Nutzer automatisch oder zur Auswahl ein Drucker aus einer Auswahl angeboten werden, wenn dieser die gleichen Ergebnisse liefert wie ein anderer Drucker einer Standardauswahl. Auf diese Weise kann mit hoher Flexibilität gedruckt werden und es ergibt sich automatisch ein sogenannter Auslastungsausgleich (load balancing). D. h. die verfügbaren Drucker werden im Wesentlichen gleich belastet. Zudem erlaubt das System nicht, das Jobs unkalibriert ausgegeben werden. So werden nur kalibrierte Drucker zum Auslastungsausgleich herangezogen.

Gemäß der Erfindung ist in vorteilhafter Weise darüber hinaus vorgesehen, eine Vollständigkeitsinformation mit dem Proof auszudrucken. In vorteilhafter Weise handelt es sich dabei um ein Logo. Sind sämtliche Parameter gültig, d. h. die erforderliche Transformationsdatei für die Farbraumtransformation der Daten und die Kalibrierungsdatei angewandt, dabei die Kalibrierungsdatei gültig und sämtliche überprüfbaren Parameter im Vorgabebereich, wird ein vollständiges Logo gedruckt. Erfindungsgemäß kann vorgesehen sein, bestimmte Bereiche des Logos nicht mit zu drucken, beispielsweise, wenn bestimmte Vorgaben nicht erfüllt sind. Dies kann beispielsweise ein bestimmter farblicher Bereich sein, der weggelassen wird, so dass andere, beispielsweise rot, dominanter werden. Auch ist es möglich, statt weglassen von Teilen Farbverschiebungen vorzunehmen und das Logo entsprechend auszudrucken. Ein beispielsweise nur rotes Logo zeigt an, dass dieser Druck aufgrund der Vorgaben nicht ok sein sollte.

Für den Fachmann bekannt ist auch die Verwendung eines sogenannten ICC-Standards. Dieses ist ein international definierter Standard auf CieL*a*b-Werten basierend. Für einen die Druckmaschine betreffenden Farbraum, beispielsweise ISO 39, gibt es somit eine Konvertierungstabelle, mit welcher die Werte des ISO-Farbraumes auf die CieL*a*b-Werte des ICC-Farbraumes konvertiert werden. Ebenso gibt es entsprechende Look-up-Tables oder Konvertierungstabellen, mit welchen die ICC- CieL*a*b-Werte in Werte im Farbraum des Digitaldruckers konvertiert werden. Es wird also nicht direkt von ISO auf den Digitaldruckerfarbraum transferiert, sondern die Werte werden über den Umweg des CieL*a*b Farbraums des ICC-Standards transferiert. Im Stand der Technik ist man so vorgegangen, dass in diesem Fall bei Abweichungen die Konvertierungstabelle ICC auf Digitaldrucker neu erstellt wurde. Mit der Erfindung ist es nunmehr möglich, eine solche Grundtabelle zu erstellen, die dann in erfindungsgemäßer Weise um eine Kalibrierungstabelle oder ein Kalibrierungsset ergänzt wird. Hierdurch wird ermöglicht, die Vorteile der Erfindung auch mit Profilen des internationalen ICC-Standards zu nutzen.

Mit der Erfindung wird ein erheblich verbessertes Verfahren zur Herstellung von Testdrucken, sogenannten Colorproofs, bereitgestellt, welches die Produktionssicherheit dahingehend erhöht, dass die Reproduktion von Drucken deutlich gesicherter ist, welches die Genauigkeit der Wiedergabe im Proof erheblich erhöht und darüber hinaus die Flexibilität hinsichtlich der Druckführung verbessert.

Weitere Vorteile und Merkmale der Erfindung ergeben sich aus der folgenden Beschreibung anhand der Figuren. Dabei zeigen:
- Fig. 1: eine Zuordnung von Ausgangsfarbraum zu Zielfarbraum und
- Fig. 2: eine Zuordnung von definiertem Druckerzustand zu Messgerät.

Ausgangspunkt ist ein Datensatz, welcher die digitalen Druckdaten zur Erstellung eines Druckergebnisses auf einer industriellen Druckmaschine beinhaltet. Diese Daten zielen auf Datenpunkte im Ausgangsfarbraum der Druckmaschine. Ein solcher Ausgangsfarbraum ist beispielsweise ISO 39.

Ein Nutzer möchte einen Colorproof auf einem vorhandenen Digitaldrucker erstellen, beispielhaft wurde ein EPSON 4800 gewählt.

Dieser EPSON 4800 kann in unterschiedlichen Zuständen eingesetzt werden, so dass sich unterschiedliche Zuordnungstabellen, mit MX4 bezeichnet, ergeben.

Ein Nutzer wählt also seinen Ausgangfarbraum und den jeweiligen Drucker in dem gewünschten Zustand. Es erfolgt dann eine Transformation der digitalen Druckdaten vom Ausgangsfarbraum in den Zielfarbraum unter Verwendung der jeweils zugehörigen MX4-Tabelle.

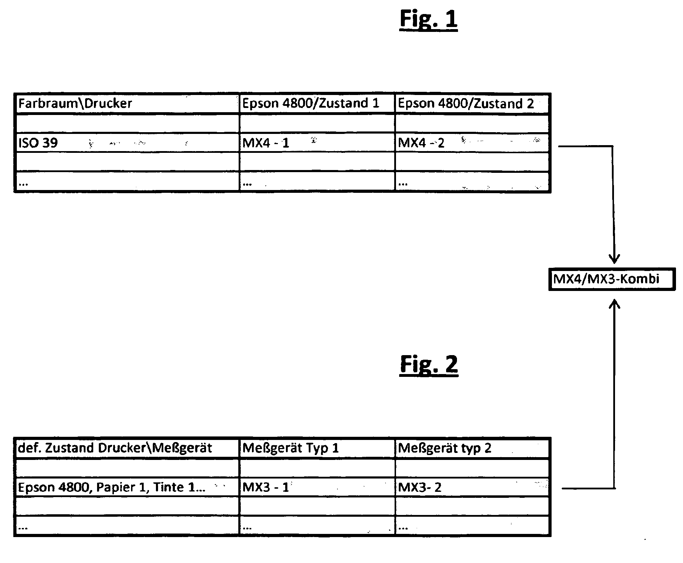

Der Drucker EPSON 4800 wurde beispielsweise im Zustand 1, ausgestattet mit Papier 1 und Tintentyp 1, kalibriert. Je nach verwendetem Messgerät wurde eine Kalibrierungsdatei - in Fig. 2 mit MX3 bezeichnet - erzeugt.

Ausgehend davon, dass die MX3-Tabellen jeweils gültig sind, kann nun der Nutzer auf einfache Weise eine MX4/MX3 Kombination auswählen und sehr genaue, reproduzierbare Ergebnisse ausdrucken.

MX4/MX3-Kombinationen, die zum identischen Ausgabeergebnis führen, werden vom System erkannt und dem Nutzer wird gegebenenfalls angeboten, dass er das gleiche Zielergebnis auch auf einem anderen Drucker erreichen kann. Auf diese Weise kann ein Auslastungsausgleich erfolgen.

Die beschriebenen Ausführungsbespiele dienen nur der Erläuterung und sind nicht beschränkend.

## Patentansprüche

1. Verfahren zur Herstellung von Testdrucken (Proof) von für den Druck auf einer industriellen Druckmaschine vorgesehenen Druckdaten auf einem Digitaldrucker, wobei die Druckdaten aus einem Farbraum für eine gegebene industrielle Druckmaschine in digitale Proof-Druckdaten in einen Farbraum für einen gegebenen Digitaldrucker in Abhängigkeit von einem gegebenen Zustand anhand von Konvertierungstabellen konvertiert werden,
wobei der gegebene Zustand Parameter wie Papiertyp, Tinte, Druckmodus umfasst, und wobei Konvertierungsdaten für eine Kalibrierungsdatei für den Drucker anhand von Farbraum kompatiblen Daten durch Druckern eines Testbildes oder Teststreifens, Messen desselben und Vergleichen mit einem druckertypischen Sollbild ermittelt und beim Druckvorgang berücksichtigt werden,
wobei bei der Ermittlung der Korrekturdaten Parameter berücksichtigt werden, die von einem bei der Vermessung des Testbildes verwendeten Messgerät abhängig sind.

2. Verfahren nach Anspruch 1, **dadurch gekennzeichnet, dass** das zu druckende Testbild sowie die Sollwerte in Abhängigkeit vom verwendeten Messgerät ausgewählt werden.

3. Verfahren nach einem der vorhergehenden Ansprüche, **dadurch gekennzeichnet, dass** die Korrekturdaten einer Gültigkeitskontrolle unterzogen werden.

4. Verfahren nach Anspruch 3, **dadurch gekennzeichnet, dass** die Periode für die Durchführung der Gültigkeitskontrolle festlegbar ist.

5. Verfahren nach einem der Ansprüche 3 oder 4, **dadurch gekennzeichnet, dass** für die Korrekturdaten ein Gültigkeitszeitraum festlegbar ist.

6. Verfahren nach einem der vorhergehenden Ansprüche, **dadurch gekennzeichnet, dass** die Korrekturdaten mit einem Toleranzspektrum versehbar sind.

7. Verfahren nach einem der vorhergehenden Ansprüche, **dadurch gekennzeichnet, dass** der Drucker einen Text auf dem Proof ausdruckt, auf welchem Abweichungen zu Sollwerten enthalten sind.

8. Verfahren nach einem der vorhergehenden Ansprüche, **dadurch gekennzeichnet, dass** auf dem Testdruck ein Qualitätslogo ausgedruckt wird.

9. Verfahren nach einem der vorhergehenden Ansprüche, **dadurch gekennzeichnet, dass** ergebnisgleiche Kombinationen von Konvertierungstabellen und Kalibrierungsdateien einer Standardauswahl zugeordnet werden.

10. Verfahren nach Anspruch 9, **dadurch gekennzeichnet, dass** unterschiedliche Drucker aus einer Standardauswahl für einen Auslastungsausgleich zur Auswahl gestellt werden.

## Claims

1. A method for producing proofs of printing data intended for printing on an industrial printing press on a digital printer, wherein the printing data is converted from a colour space for a given industrial printing press into digital proof printing data in a colour space for a given digital printer as a function of a given state by means of conversion tables, wherein the given state comprises parameters such as paper type, ink, printing mode, and wherein conversion data for a calibration file for the printer is determined by means of colour space compatible data through printing of a proof image or proof strip, measuring of the latter and comparing with a printer-typical desired image and taken into account during the printing operation, wherein during the determination of the correction data parameters are taken into account which are dependent on a measuring device used during the measuring of the proof image.

2. The method according to Claim 1, **characterized in that** the proof image to be printed and the desired values are selected as a function of the measuring device used.

3. The method according to any one of the preceding claims, **characterized in that** correction data is subjected to a validity check.

4. The method according to Claim 3, **characterized in that** the period for carrying out the validity check can be determined.

5. The method according to any one of the Claims 3 or 4, **characterized in that** for the correction data a validity period can be determined.

6. The method according to any one of the preceding claims, **characterized in that** the correction data can be provided with a tolerance spectrum.

7. The method according to any one of the preceding claims, **characterized in that** the printer prints out a text on the proof on which deviations to desired values are included.

8. The method according to any one of the preceding claims, **characterized in that** on the proof print a quality logo is printed out.

9. The method according to any one of the preceding claims, **characterized in that** result-identical combinations of conversion tables and calibration files are assigned to a standard selection.

10. The method according to Claim 9, **characterized in that** different printers from a standard selection are made available for selection for utilisation compensation.

## Revendications

1. Procédé de fabrication d'épreuves en couleur sur une imprimante numérique pour des données d'impression prévues pour l'impression sur une presse industrielle, sachant que les données d'impression sont converties d'un espace chromatique pour une pression industrielle définie, en données d'impression d'épreuve numériques dans un espace chromatique pour une imprimante numérique définie, en fonction d'un état défini, à l'aide de tableaux de conversion,
sachant que l'état défini comprend des paramètres comme le type de papier, l'encre, le mode d'impression et sachant que des données de conversion pour un fichier de calibrage pour l'imprimante sont déterminées à l'aide de données compatibles avec l'espace chromatique par l'impression d'une image test ou d'une bande test, la mesure de ces dernières et la comparaison avec une image nominale typique de l'imprimante, et sont prises en compte lors de la procédure d'impression,
sachant que lors de la détermination des données de correction, des paramètres sont pris en compte, lesquels sont fonction d'un appareil de mesure employé lors du mesurage de l'image test.

2. Procédé selon la revendication 1, **caractérisé en ce que** l'image test à imprimer ainsi que les valeurs nominales doivent être sélectionnées en fonction de l'appareil de mesure employé.

3. Procédé selon la revendication 1 ou 2, **caractérisé en ce que** les données de correction sont soumises à un contrôle de validité.

4. Procédé selon la revendication 3, **caractérisé en ce que** la période d'exécution du contrôle de validité peut être déterminée.

5. Procédé selon la revendication 3 ou 4, **caractérisé en ce qu'**une durée de validité peut être déterminée pour les données de correction.

6. Procédé selon l'une des revendications précédentes, **caractérisé en ce que** les données de correction peuvent être dotées d'un spectre de tolérances.

7. Procédé selon l'une des revendications précédentes, **caractérisé en ce que** l'imprimante imprime un texte sur l'épreuve en couleur, sur lequel figurent des écarts par rapport aux valeurs nominales.

8. Procédé selon l'une des revendications précédentes, **caractérisé en ce qu'**un logo de qualité est imprimé sur l'épreuve en couleur.

9. Procédé selon l'une des revendications précédentes, **caractérisé en ce que** des combinaisons semblables au résultat des tableaux de conversion et des données de calibrage peuvent être attribuées à une sélection standard.

10. Procédé selon la revendication 9, **caractérisé en ce que** différentes imprimantes d'une sélection standard sont présentées en sélection pour une comparaison des utilisations.
